(19) **Europäisches Patentamt / European Patent Office / Office européen des brevets**

(11) **EP 1 843 473 A1**

(12) **EUROPEAN PATENT APPLICATION**

(43) Date of publication:
**10.10.2007 Bulletin 2007/41**

(51) Int Cl.:
***H03M 5/06*** (2006.01)

(21) Application number: **07105520.6**

(22) Date of filing: **03.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **05.04.2006 FR 0602996**

(71) Applicant: **Alcatel Lucent**
**75008 Paris (FR)**

(72) Inventors:
• **Godin, Jean**
  **94100 SAINT MAUR DES FOSSES (FR)**
• **Lefrancois, Mathieu**
  **91140 VILLEBON SUR YVETTE (FR)**

(74) Representative: **Bréda, Jean-Marc et al**
**Marks & Clerk France**
**31-33, Avenue Aristide Briand**
**94117 Arcueil Cedex (FR)**

(54) **Method of encoding a binary signal**

(57)    The field of the invention is that of the encoding of binary signals used in particular in optical telecommunication systems. There are various encoding systems that can be used to transmit such signals. The method according to the invention makes it possible to generate an amplitude-modulated binary signal, each bit of the signal having a duration T and the binary value of each bit being determined by the value of the amplitude of the signal at the end of each duration T, the amplitude of said signal being modulated so that the average energy during each duration T is roughly constant. Preferably, the amplitude variation of each bit during each duration T is determined by the value of said bit and by that of the preceding bit. A specific circuit for performing the encoding according to the invention is also described.

A decoding method making it possible to detect errors by oversampling is also described.

FIG. 3

**EP 1 843 473 A1**

**Description**

The field of the invention is that of the encoding of binary signals used in particular in optical telecommunication systems.

It is known that a digital signal is made up of a succession of digital bits having as possible states "0" or "1", each bit having a duration T. There are various encoding systems that can be used to transmit such signals.

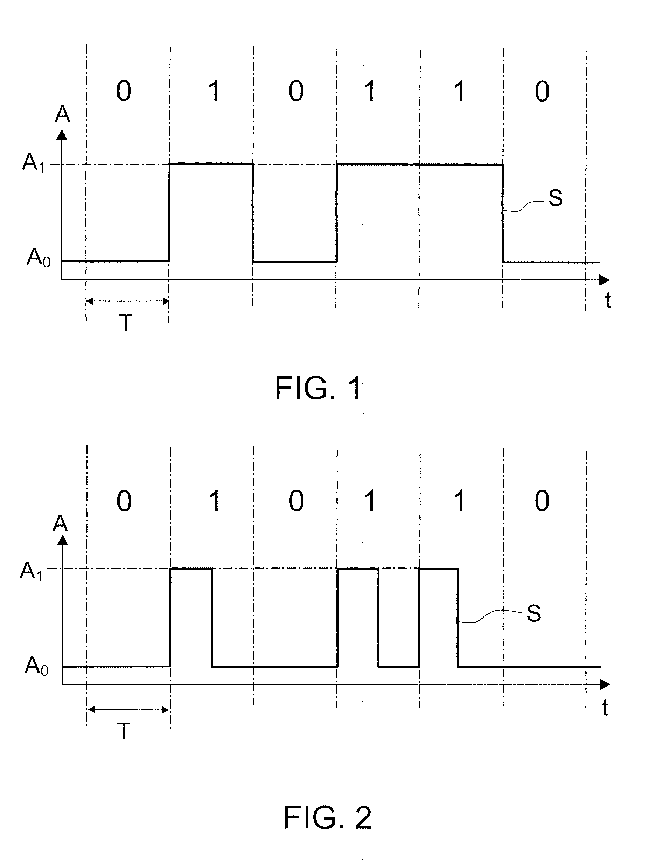

A first signal is illustrated in Figure 1. The variations of the successive binary states are indicated on a horizontal line in this figure. The amplitude of the encoded signal S according to the time t is represented under this line. It is the so-called NRZ (Non-Return to Zero) system. In this case, the encoding is simple. Each state has a corresponding constant amplitude level of the binary signal S. Thus, the level $A_0$ corresponds to the "0" state and the level $A_1$ corresponds to the "1" state, the level $A_0$ being less than the level $A_1$ as represented in Figure 1. During each duration T, the amplitude of the signal is therefore $A_0$ or $A_1$.

A second system is illustrated in Figure 2. This is the so-called RZ (Return to Zero) system. In this case, the encoding of the "0" state is always handled by a constant amplitude level $A_0$. However, during a duration T, the "1" level is encoded by a rise in the amplitude of the level $A_0$ to the level $A_1$ then a return from the level $A_1$ to the level $A_0$. The amplitude variations of the signal S are then as shown in Figure 2.

There are other encoding systems. However, these systems all present the drawback that a long succession of bits having the same state can result in an absence of amplitude variation in the signal for a long period. This absence of variation can have consequences that are prejudicial to the correct transmission of the signal.

This phenomenon is particularly significant with transmissions by optical fibres. In practice, with strong light power, there are non-linear effects like the Kerr effect, which causes modifications of the optical index of the optical fibre according to the transmitted light power. These effects disrupt the transmission of the signal. It is, of course, possible to use phase encodings that are known to improve the resistance to impairments induced by the non-linear effects. However, optical phase encoding requires interferometric devices that are complex and difficult to implement.

Also, the method according to the invention makes it possible to produce a binary signal, the average energy of which during the duration T of each bit of the signal is roughly constant, without recourse to the phase modulation techniques.

More specifically, the subject of the invention is a method of encoding an amplitude-modulated binary signal between two minimum and maximum values, each bit of the signal having a duration T and the binary value of each bit being determined by the value of the amplitude of the signal at the end of each duration T, characterized in that the amplitude of said signal is modulated so that the average energy during each duration T is roughly constant.

Advantageously, the amplitude variation of each bit during each duration T is determined by the value of said bit and by that of the preceding bit.

The invention also relates to an electronic circuit for generating a binary signal consisting of bits having a duration T, each succession of two consecutive bits of the signal being able to take respective values defining four states denoted "0, 0", "0, 1 ", "1, 0" and "1,1", said circuit comprising at least:

- a generator of four primary signals respectively associated with these said four states:

    - a first periodic primary signal, the period of said signal being equal to T;
    - a second periodic primary signal, the period of said signal being equal to T, said second signal being phase-shifted by a duration equal to T/2 relative to the first primary signal;
    - a third periodic primary signal, the period of said signal being equal to 2T;
    - a fourth periodic primary signal, the period of said signal being equal to 2T, said fourth signal being phase-shifted by a duration equal to T relative to the third primary signal;

- electronic selection means controlled by the states of the successive bits making it possible to generate the signal from the four primary signals, said means being arranged so that, for each duration T for which two successive bits define a given state, the final signal results from the selection during this duration of that of the four primary signals which is associated with said given state.

Advantageously, the association of the primary signals and of the possible states of two successive bits is as follows:

- first primary signal associated with the state "0, 0";
- second primary signal associated with the state "1, 1 ";
- third primary signal associated with the state "0, 1 ";
- fourth primary signal associated with the state "1, 0".

Advantageously, the electronic circuit further comprises a logic block making it possible to generate four logic signals respectively associated with the four possible states of two successive bits, the logic state of a logic signal being 1 when said successive bits define a state associated with said logic signal and 0 in the other cases.

Advantageously, the selection means comprise means for calculating the sum of the four products of the logic signals by the primary signals.

Finally, the signal can be an optical signal and the selection means are mainly electronically controlled optical gates.

The invention also relates to a decoding method associated with the preceding encoding, said method having a first decoding step consisting in sampling the signal, the amplitudes of the samples obtained being located either side of a reference value, at least one first and one second sample being obtained at the end of the duration of a first bit and at the end of the duration of a second bit succeeding the first bit so as to determine the binary value of said bits according to said reference value, the decoding method being characterized in that:

- at least one third sample is obtained between the first and the second samples;
- the method comprises a step for validating the binary values of the first bit and of the second bit dependent on the comparison of the amplitude of said third sample relative to the amplitudes of the first and second samples.

Advantageously, the decoding method is such that:

- two so-called low and high values are determined, the low value being less than the reference value and the high value being greater than the reference value;
- a sampling is performed in the middle of the duration of each bit of the encoded signal;

the decoding method comprising at least:

- a second step consisting in determining whether the amplitude of said sample obtained is:

  o less than the low value;
  o between the low value and the high value;
  o greater than the high value;

- a third step consisting in determining, according to the result of the second step, the type of transition existing between the sampled bit and the following bit, the transition types being:

  o conservation of the binary level at the "0" level;
  o conservation of the binary level at the "1" level;
  o change of binary level;

- a fourth step consisting in determining, according to the result of the first step, the type of transition existing between the sampled bit and the following bit;
- a fifth, validation, step consisting in comparing the transition successions obtained by the third step and the fourth step.

The invention will be better understood, and other advantages will become apparent, from reading the description that follows, given by way of non-limiting example, and from the appended figures in which:

- Figure 1 represents an NRZ-type binary signal encoding;
- Figure 2 represents an RZ-type binary signal encoding;
- Figure 3 represents a binary signal encoding according to the invention;
- Figure 4 represents a theoretical implementation of an electronic circuit for generating a signal according to the invention;
- Figure 5 represents the time variations of the various signals implemented by the preceding electronic circuit;
- Figure 6 represents the principle of a binary signal decoding according to the invention.

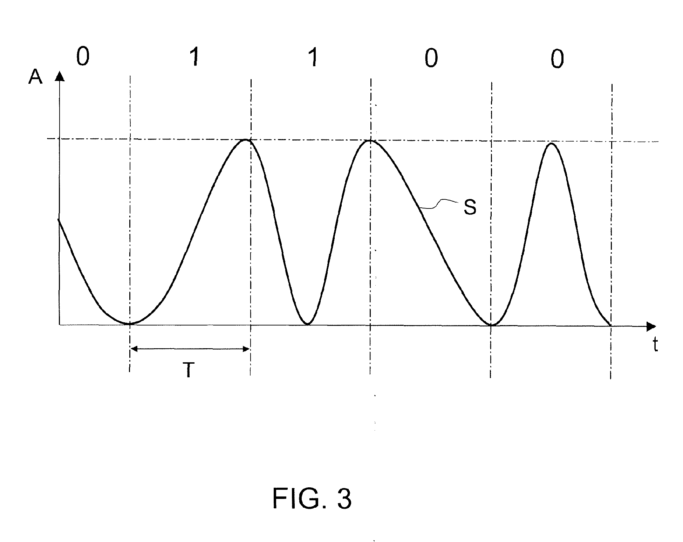

Figure 3 represents an encoding of a binary signal S according to the invention. The aim of the encoding is to obtain a signal with an amplitude:

- that is representative of the binary value of the bits during a certain part of the duration T of said bits;
- that is modulated so that the average energy during the duration T of each bit is roughly constant.

There are, of course, various methods that can be used to obtain these effects. As a non-limiting example, a method according to the invention relies on the following two principles:

- the amplitude of the signal at the end of the duration of each bit is representative of the value of the bit. Thus, the following convention can be adopted: if the amplitude of the signal oscillates between a minimum level $A_0$ and a maximum level $A_1$, when the bit is at the "0" level, the amplitude of the signal is roughly $A_0$ at the end of the duration of this bit and when the bit is at the "1" level, the amplitude of the signal is roughly $A_1$ at the end of the duration of this bit. It would also be possible to adopt the reverse convention, that is, when the bit is at the "0" level, the amplitude of the signal is roughly $A_1$ at the end of the duration of this bit and when the bit is at the "1" level, the amplitude of the signal is roughly $A_0$ at the end of the duration of this bit;
- the amplitude variation of each bit during each duration T is determined by the value of said bit and by that of the preceding bit:

   o when two successive bits have the same state to which a first amplitude level corresponds, the amplitude of the signal representative of the second bit necessarily goes through the level opposite to this first amplitude level. For example, on a succession of two bits with the "0" state, to which the minimum amplitude level $A_0$ corresponds, the amplitude of the signal goes through the maximum amplitude $A_1$;
   o when two successive bits have different states, the amplitude of the signal continuously changes from a first amplitude level to a second amplitude level.

As an example, by adopting the convention: if the amplitude of the signal oscillates between a minimum value $A_0$ and a maximum value $A_1$, when the bit is at the "0" level, the amplitude of the signal is roughly $A_0$ at the end of the duration of this bit and when the bit is at the "1" level, the amplitude of the signal is roughly $A_1$ at the end of the duration of this bit, the following are obtained:

- when the binary value of the bit is "1" and the binary value of the preceding bit is "0", the amplitude variation of the signal during the duration T of the bit is an increasing monotonic function changing from the minimum value to the maximum value;
- when the binary value of the bit is "1" and the binary value of the preceding bit is "1", the amplitude variation of the signal during the duration T of the bit is a function that first decreases from the maximum value to the minimum value, then increases from the minimum value to the maximum value;
- when the binary value of the bit is "0" and the binary value of the preceding bit is "1", the amplitude variation of the signal during the duration T of the bit is a decreasing monotonic function changing from the maximum value to the minimum value;
- when the binary value of the bit is "0" and the binary value of the preceding bit is "0", the amplitude variation of the signal during the duration T of the bit is a function that first increases from the minimum value to the maximum value, then decreases from the maximum value to the minimum value.

Figure 3 represents the variations in the amplitude of the binary signal S according to the time t for the four possible binary state changes which are: "0, 1 ", "1, 1 ", "1, 0" and "0, 0".

And by adopting the reverse convention, the following would be obtained:

- when the binary value of the bit is "1" and the binary value of the preceding bit is "0", the amplitude variation of the signal during the duration T of the bit is a decreasing monotonic function changing from the maximum value to the minimum value;
- when the binary value of the bit is "1" and the binary value of the preceding bit is "1", the amplitude variation of the signal during the duration T of the bit is a function that first increases from the minimum value to the maximum value, then decreases from the maximum value to the minimum value;
- when the binary value of the bit is "0" and the binary value of the preceding bit is "1", the amplitude variation of the signal during the duration T of the bit is an increasing monotonic function changing from the minimum value to the maximum value;
- when the binary value of the bit is "0" and the binary value of the preceding bit is "0", the amplitude variation of the signal during the duration T of the bit is a function that first decreases from the maximum value to the minimum value, then increases from the minimum value to the maximum value.

Such an encoding can be implemented in various ways.

As a first example, it is possible to use two three-state digital-analogue converters connected in parallel.

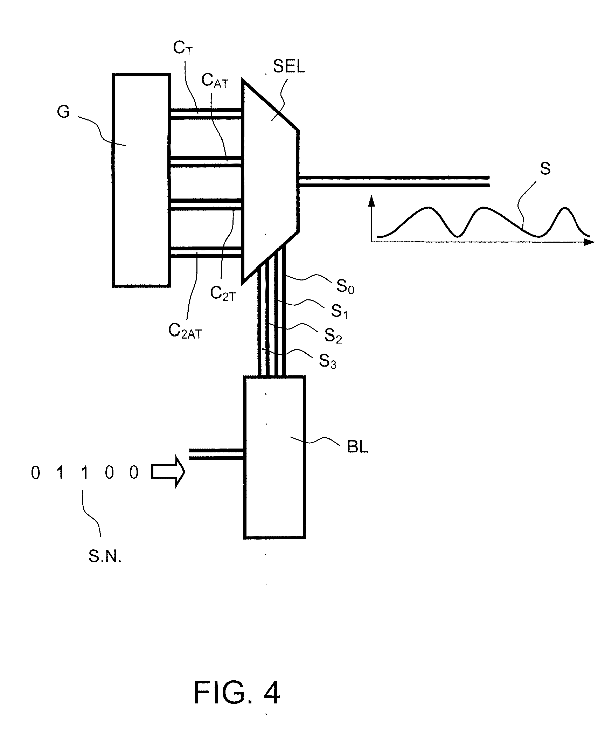

As a second example illustrated in Figure 4, it is possible to use an electronic circuit comprising:

- a generator G of four primary signals;
- electronic selection means SEL controlled by the states of the successive bits of the digital signal S.N. making it possible to generate the signal S from the four primary signals, said means being arranged so that, for each duration T for which two successive bits define a given state, the final signal results from the selection during this duration of that of the four primary signals which is associated with said given state.

The electronic circuit can comprise a logic block BL for generating four logic signals ($S_0$, $S_1$, $S_2$ and $S_3$) respectively associated with the four possible states of two successive bits, the logic state of a logic signal being 1 when said successive bits define a state associated with said logic signal and 0 in the other cases.

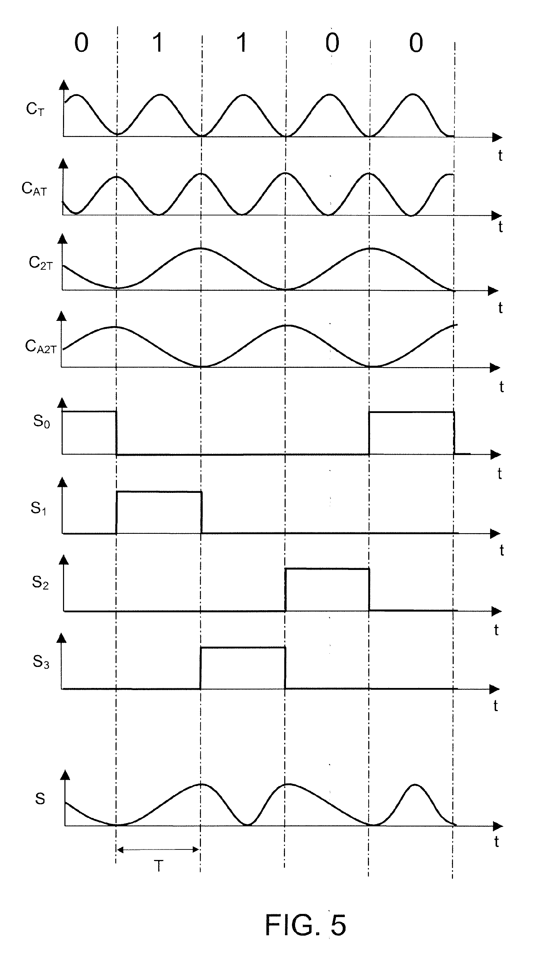

As an example, Figure 5 represents the time variations of the various signals needed for the electronic circuit. In this figure, the time t is on the X axis and the intensity of the various signals on the Y axis. The thin vertical lines are separated by a duration equal to a period T.

The four primary signals are respectively:

- a first periodic primary signal $C_T$, the period of said signal being equal to T;
- a second periodic primary signal $C_{AT}$, the period of said signal being equal to T, said second signal being phase-shifted by a duration equal to T/2 relative to the first primary signal $C_T$;
- a third periodic primary signal $C_{2T}$, the period of said signal being equal to 2T;
- a fourth periodic primary signal $C_{A2T}$, the period of said signal being equal to 2T, said fourth signal being phase-shifted by a duration equal to T relative to the third primary signal $C_T$.

During a period T, 2 successive bits can have only one of the following four possible states: "0, 0", "0, 1", "1, 0", "1, 1 ". Consequently, it is possible to associate with each possible state one of the four primary signals, each of these signals corresponding to one of the four possible forms of the signal as they have been defined previously. The final signal then comprises the succession of the selected primary signals. Of course, the generation of the primary signals $C_T$, $C_{AT}$, $C_{2T}$ and $C_{A2T}$ poses no technical problem.

The purpose of the selection means is to select the correct primary signal corresponding to the various states of two successive bits. To this end, it is possible to use a logic block which, from the digital signal, generates four logic signals $S_0$, $S_1$, $S_2$ and $S_3$ respectively associated with the four possible states of two successive bits, the logic state of a logic signal being 1 when the state of two successive bits defines a state associated with said logic signal and 0 in the other cases. These signals are represented in Figure 5. For example, $S_1$ is "1" when the state of two successive bits is "0, 1" and $S_1$ is "0" when the state of two successive bits is "0, 0", "1, 0" and "1, 1 ". The generation of these logic signals, which is done at a frequency F that is the inverse of the duration T, raises no technical implementation problems.

Thus, the four logic signals are representative of the different states of two successive bits. Each of the four logic signals controls the selection of one of the four primary signals. The selected primary signal thus corresponds to the state associated with the digital signal.

As an example, by taking the functions represented in Figure 5 where $S_0$ is associated with the state "0, 0", $S_1$ is associated with the state "0, 1 ", $S_2$ is associated with the state "1, 0", $S_3$ is associated with the state "1, 1 ", the logic operation performed by the selection means is then as follows:

$$S = C_T . S_0 + C_{2T} . S_1 + C_{2AT} . S_2 + C_{AT} . S_3$$

The electronic circuits can operate correctly with a certain phase shift. This phase margin is conventionally called CPM, standing for Clock Phase Margin. The encoding according to the invention makes it possible to obtain a phase margin at least equivalent to that of an RZ-type encoding.

The decoding of the signals transmitted according to this encoding poses no particular technical problem. The decoding can be done either conventionally, or using oversampling methods. The normal reception devices can be retained for the decoding.

The use of oversampling techniques makes it possible, in particular, to confirm the identification of the preceding and following binary elements.

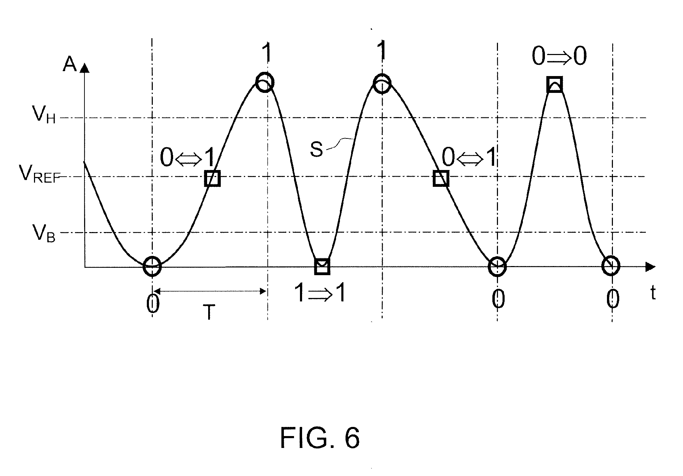

As a non-limiting example, Figure 6 takes up the wave-form presented in Figure 3, representative of a transmitted signal. The durations of the bits of the signal are equal to T. The conventional decoding uses a reference value $V_{REF}$. The comparison of the amplitude A of the signal with the reference value $V_{REF}$ is done at the end of each period T. The comparison points are indicated by circles in Figure 6. An amplitude A that is less than the reference value corresponds to the binary value "0", whereas an amplitude A greater than the reference value corresponds to the binary value "1".

The oversampling mode consists in introducing an additional comparison in the middle of each bit time, the comparison is then done relative to two reference levels $V_H$ and $V_B$ respectively less than and greater than the reference value $V_{REF}$. The comparison points are indicated by squares in Figure 6. An amplitude A that is less than $V_B$ confirms a preceding decision of a binary "1" value and a future decision of a binary "1" value, symbolized in Figure 6 by the symbol 1⇒1. Similarly, an amplitude A that is greater than $V_H$ confirms a preceding decision of a binary "0" value and a future decision of a "0" value, symbolized in Figure 6 by the symbol 0⇒0. Finally, an amplitude A that is greater than $V_B$ and less than $V_H$ confirms a transition, either from "0" to "1", or from "1" to "0", symbolized in Figure 6 by the symbol 0⇒1. It will be noted that, in this last case, it is not possible to determine the direction of the transition. However, in case of a bad transition, for the error not to be detected, two successive bits would both have to be false.

This mechanism thus makes it possible to detect wrong decisions, a necessary basis for implementing the normal error correction techniques.

**Claims**

1. Method of encoding an amplitude-modulated binary signal between two minimum and maximum values, each bit of the signal having a duration T and the binary value of each bit being determined by the value of the amplitude of the signal at the end of each duration T, **characterized in that** the amplitude of said signal is modulated so that the average energy during each duration T is roughly constant, the amplitude variation of each bit during each duration T is determined by the value of said bit and by that of the preceding bit and the amplitude of the signal at the end of the duration of each bit is representative of the value of the bit.

2. Encoding method according to Claim 1, **characterized in that**:

   • when the binary value of the bit is "1" and the binary value of the preceding bit is "0", the amplitude variation of the signal during the duration T of the bit is an increasing monotonic function changing from the minimum value to the maximum value;
   • when the binary value of the bit is "1" and the binary value of the preceding bit is "1", the amplitude variation of the signal during the duration T of the bit is a function that first decreases from the maximum value to the minimum value, then increases from the minimum value to the maximum value;
   • when the binary value of the bit is "0" and the binary value of the preceding bit is "1", the amplitude variation of the signal during the duration T of the bit is a decreasing monotonic function changing from the maximum value to the minimum value;
   • when the binary value of the bit is "0" and the binary value of the preceding bit is "0", the amplitude variation of the signal during the duration T of the bit is a function that first increases from the minimum value to the maximum value, then decreases from the maximum value to the minimum value.

3. Encoding method according to Claim 1, **characterized in that**:

   • when the binary value of the bit is "1" and the binary value of the preceding bit is "0", the amplitude variation of the signal during the duration T of the bit is a decreasing monotonic function changing from the maximum value to the minimum value;
   • when the binary value of the bit is "1" and the binary value of the preceding bit is "1", the amplitude variation of the signal during the duration T of the bit is a function that first increases from the minimum value to the maximum value, then decreases from the maximum value to the minimum value;
   • when the binary value of the bit is "0" and the binary value of the preceding bit is "1", the amplitude variation of the signal during the duration T of the bit is an increasing monotonic function changing from the minimum value to the maximum value;
   • when the binary value of the bit is "0" and the binary value of the preceding bit is "0", the amplitude variation of the signal during the duration T of the bit is a function that first decreases from the maximum value to the minimum value, then increases from the minimum value to the maximum value.

4. Electronic circuit for generating a binary signal according to one of Claims 1 to 3, each bit having a duration T, each succession of two consecutive bits of the signal being able to take respective values defining four states denoted "0, 0", "0, 1 ", "1, 0" and "1,1", said circuit comprising at least:

   • a generator (G) of four primary signals respectively associated with these said four states:

      • a first periodic primary signal ($C_T$), the period of said signal being equal to T;

• a second periodic primary signal ($C_{AT}$), the period of said signal being equal to T, said second signal being phase-shifted by a duration equal to T/2 relative to the first primary signal ($C_T$);
• a third periodic primary signal ($C_{2T}$), the period of said signal being equal to 2T;
• a fourth periodic primary signal ($C_{A2T}$), the period of said signal being equal to 2T, said fourth signal being phase-shifted by a duration equal to T relative to the third primary signal ($C_T$);

• electronic selection means (SEL) controlled by the states of the successive bits making it possible to generate the signal from the four primary signals, said means being arranged so that, for each duration T for which two successive bits define a given state, the final signal results from the selection during this duration of that of the four primary signals which is associated with said given state.

5. Electronic circuit according to Claim 4, **characterized in that** the association of the primary signals and of the possible states of two successive bits is as follows:

• first primary signal associated with the state "0, 0";
• second primary signal associated with the state "1, 1 ";
• third primary signal associated with the state "0, 1 ";
• fourth primary signal associated with the state "1, 0".

6. Electronic circuit according to one of Claims 4 or 5, **characterized in that** the electronic circuit further comprises a logic block (BL) for generating four logic signals ($S_0$, $S_1$, $S_2$ and $S_3$) respectively associated with the four possible states of two successive bits, the logic state of a logic signal being 1 when said successive bits define a state associated with said logic signal and 0 in the other cases.

7. Electronic circuit according to Claim 6, **characterized in that** the selection means (SEL) comprise means for calculating the sum of the four products of the logic signals ($S_0$, $S_1$, $S_2$ and $S_3$) by the primary signals ($C_T$, $C_{AT}$, $C_{2T}$ and $C_{A2T}$).

8. Electronic circuit according to one of Claims 4 to 7, **characterized in that** the signal is an optical signal and the selection means are mainly electronically controlled optical gates.

9. Method of decoding an amplitude-modulated binary signal according to one of Claims 1 to 3, said decoding method having a first decoding step consisting in sampling the signal, the amplitudes of the samples obtained being located either side of a reference value, at least one first and one second sample being obtained at the end of the duration of a first bit and at the end of the duration of a second bit succeeding the first bit so as to determine the binary value of said bits according to said reference value, the decoding method being **characterized in that**:

• at least one third sample is obtained between the first and the second samples;
• the method comprises a step for validating the binary values of the first bit and of the second bit dependent on the comparisons of the amplitude of said third sample relative to the amplitudes of the first and second samples.

10. Decoding method according to Claim 9, **characterized in that**:

• two so-called low and high values are determined, the low value being less than the reference value and the high value being greater than the reference value;
• a sampling is performed in the middle of the duration of each bit of the encoded signal;

and the decoding method comprising at least:

• a second step consisting in determining whether the amplitude of said sample obtained is:

o less than the low value;
o between the low value and the high value;
o greater than the high value;

• a third step consisting in determining, according to the result of the second step, the type of transition existing between the sampled bit and the following bit, the transition types being:

  o conservation of the binary level at the "0" level;
  o conservation of the binary level at the "1" level;
  o change of binary level;

  • a fourth step consisting in determining, according to the result of the first step, the type of transition existing between the sampled bit and the following bit,

a fifth, validation step consisting in comparing the transition successions obtained by the third step and the fourth step.

FIG. 1

FIG. 2

FIG. 3

FIG. 4

FIG. 5

FIG. 6

**European Patent Office**

**EUROPEAN SEARCH REPORT**

Application Number

EP 07 10 5520

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 453 239 A1 (CIT ALCATEL [FR]) 1 September 2004 (2004-09-01) * column 1, line 36 - line 58; figure 1 * ----- | 1-10 | INV. H03M5/06 |

TECHNICAL FIELDS SEARCHED (IPC)

H03M

The present search report has been drawn up for all claims

| Place of search | Date of completion of the search | Examiner |
|---|---|---|
| The Hague | 2 May 2007 | Van Staveren, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 843 473 A1

## ANNEX TO THE EUROPEAN SEARCH REPORT
## ON EUROPEAN PATENT APPLICATION NO.

EP 07 10 5520

This annex lists the patent family members relating to the patent documents cited in the above-mentioned European search report.
The members are as contained in the European Patent Office EDP file on
The European Patent Office is in no way liable for these particulars which are merely given for the purpose of information.

02-05-2007

| Patent document cited in search report | | Publication date | Patent family member(s) | | Publication date |
|---|---|---|---|---|---|
| EP 1453239 | A1 | 01-09-2004 | AT | 303024 T | 15-09-2005 |
| | | | DE | 60301384 D1 | 29-09-2005 |
| | | | DE | 60301384 T2 | 09-03-2006 |
| | | | US | 2004170242 A1 | 02-09-2004 |

EPO FORM P0459

For more details about this annex : see Official Journal of the European Patent Office, No. 12/82

15